(19) **Europäisches Patentamt European Patent Office Office européen des brevets**

(11) **EP 4 663 457 A1**

(12) **EUROPEAN PATENT APPLICATION**

(43) Date of publication:
**17.12.2025 Bulletin 2025/51**

(21) Application number: **24181711.3**

(22) Date of filing: **12.06.2024**

(51) International Patent Classification (IPC):
**B60L 3/00** *(2019.01)*　　**B60L 7/10** *(2006.01)*
**B60L 58/12** *(2019.01)*　　**B60L 58/16** *(2019.01)*

(52) Cooperative Patent Classification (CPC):
**B60L 58/16; B60L 3/0046; B60L 7/10; B60L 58/12;**
B60L 2260/50; B60L 2260/52

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **VOLVO TRUCK CORPORATION 405 08 Göteborg (SE)**

(72) Inventor: **M, Madhukar 800006 PATNA (IN)**

(74) Representative: **Kransell & Wennborg KB P.O. Box 2096 403 12 Göteborg (SE)**

(54) **A METHOD FOR CONTROLLING THE SOC OPERATING WINDOW OF A BATTERY PACK**

(57)　A computer system (17) comprising processing circuitry (18) configured to: determine operating windows (140, 141, 142) of a battery pack (114) of an electric vehicle (1) defined by its state-of-charge, SOC, according to default predetermined SOC limits (140), extended predetermined SOC limits (142) and limited predetermined SOC limits (141); determine predictive energy or power utilization of the battery pack (114) for a predetermined route (301); determine a health condition of the battery pack (114); and in response to the determined health condition of the battery pack (114) and the determined predictive energy or power utilization of the battery pack (114) for the predetermined route (301), set a fixed operating window (140, 141, 142) of the battery pack (114) according to either the limited predetermined SOC limits (142), the default predetermined SOC limits (140), or the extended predetermined SOC limits (141).

*Fig. 1*

EP 4 663 457 A1

**Description**

**TECHNICAL FIELD**

The disclosure relates generally to energy and health management of a battery pack of an electric vehicle. In particular aspects, the disclosure relates to a method for controlling the State-of-Charge, SOC operating window of the battery pack. The disclosure can be applied to heavy-duty vehicles, such as trucks, buses, and construction equipment, among other vehicle types. Although the disclosure may be described with respect to a particular vehicle, the disclosure is not restricted to any particular vehicle.

**BACKGROUND**

A vehicle typically comprises an engine for propelling the vehicle. The engine may be powered by various means, such as e.g. by liquid or gaseous fuel in an internal combustion engine, or by electric power in an electric machine. Moreover, hybrid solutions exist in which the vehicle is propelled both by an internal combustion engine and an electric machine. In either way, energy storage devices are used to store the energy needed in order to operate the engine for propelling the vehicle. For an electric machine, the energy storage devices may be battery packs or supercapacitors, comprised in a rechargeable energy storage system, RESS. Both fully electrically operated vehicles and hybrid vehicles may be referred to as electric vehicles.

In an electric vehicle, the electric machine is part of a powertrain which transform energy from the energy storage system to the propelling means, typically the wheels of the vehicle. For this purpose, the powertrain further comprises transmission and drive shafts. In order to control the operation of the engine, and any related actions such as e.g. power or energy to be drawn from the RESS, the vehicle comprises a computer system comprising processing circuitry (e.g. a control unit or a control system comprising at least one control unit). For example, in a vehicle comprising an electric machine, the control unit may be configured to control the energy and power drawn from the battery pack to the electric machine by an electric machine driver which is configured to control the operation of the electric machine.

For RESS comprising a battery pack, the battery pack is normally restricted to be operated within a certain SOC operating windows. Thus, all available energy of the battery pack is typically not made available for usage. However, operating the battery outside of the restricted operating window may cause deterioration to the health of the battery pack (e.g. reduced State-of-Health, SOH). There is thus a need in the industry for an improved control of the powertrain, in particular for controlling energy or power utilization of the battery pack.

**SUMMARY**

According to a first aspect of the disclosure, a computer system comprising processing circuitry is provided. The processing circuitry is configured to: determine operating windows of a battery pack of an electric vehicle defined by its state-of-charge, SOC, according to default predetermined SOC limits, extended predetermined SOC limits in which at least one of an upper limit and a lower limit is extended compared to a corresponding upper limit or lower limit of the default predetermined SOC limits, and limited predetermined SOC limits in which at least one of an upper limit and a lower limit is more limited compared to the corresponding upper limit or lower limit of the default predetermined SOC limits; determine predictive energy or power utilization of the battery pack for a predetermined route, the predictive energy or power utilization being determined by battery pack discharging in response to power consumption of the battery pack along the predetermined route, and battery pack charging in response to power generation of the battery pack along the predetermined route using a regenerative braking system of the electric vehicle; determine a health condition of the battery pack; and in response to the determined health condition of the battery pack and the determined predictive energy or power utilization of the battery pack for the predetermined route, set a fixed operating window of the battery pack according to either the limited predetermined SOC limits, the default predetermined SOC limits, or the extended predetermined SOC limits. The first aspect of the disclosure may seek to overcome problems relating to deteriorated health condition of the battery pack related to the choice of SOC operating window. A technical benefit may include control of the deterioration of the health condition of the battery pack while considering storing energy in the battery pack of the electric vehicle. Utilization of the extended predetermined SOC limits of the battery pack results in that more energy can be stored in the battery pack and/or that more energy of the batter pack can be utilized, at the expense of a relatively high deterioration of the health condition of the battery pack. Utilization of the limited predetermined SOC limits of the battery pack results in that less energy can be stored in the battery pack and/or that less energy of the batter pack can be utilized, at the benefit of a relatively low deterioration of the health condition of the battery pack. Thus, by setting the operating window to a fixed operating window in response to the determined health condition of the battery pack and the determined predictive energy or power utilization of the battery pack for the predetermined route, deterioration of the health condition of the battery pack can be better controlled with regards to the utilization of the energy storage and/or energy utilization of the battery pack. That is, the health condition of the battery pack and the determined predictive energy or power utilization of the battery pack for the predetermined route are used as input to determine the fixed operating SOC window of the battery pack according to either the limited predetermined SOC limits, the default predetermined SOC limits, or the extended predetermined SOC limits. It should be understood that the electric vehicle comprises a regenerative braking system configured to charge the battery pack during braking of the electric vehicle. The first aspect of the disclosure may provide an energy management of the battery pack that utilizes the health condition of the battery pack and the various (different) predetermined SOC limits for determining and providing improved utilization of the energy storage and/or energy utilization of the battery pack adapted to the battery pack health condition.

Optionally in some examples, including in at least one preferred example, the processing circuitry is further configured to: identify a vehicle condition along the predetermined route as belonging to a group of predefined vehicle conditions defined as regenerative limiting, the regenerative limiting being defined as vehicle conditions in which charging of the battery pack by the regenerative braking system to its fully charged level occurs somewhere along the predetermined route, the fully charged level being set by the upper limit of the default predetermined SOC limits. A technical benefit may include that the extended predetermined SOC limits can be utilized in an advantageous manner. The predictive energy or power utilization of the battery pack can be evaluated and compared to the default predetermined SOC limits of the battery pack, and if the predictive energy or power utilization of the battery pack, somewhere along the predetermined route, indicates that the fully charged level for the battery pack will be reached (i.e. the upper limit of the default predetermined SOC limits), a vehicle condition defined as regenerative liming is identified. Hereby, the battery pack may be operated within the fixed operating window defined by the extended predetermined SOC limits in order to improve utilization of the regenerative braking system. In other words, the processing circuitry may be configured to compare the predicted energy or power utilization of the battery pack for the predetermined route with a preset threshold (e.g. that of the upper limit of the default predetermined SOC limits), wherein a predicted energy or power utilization above the preset threshold somewhere along the predetermined route is defined to correspond to a vehicle condition defined as regenerative limiting. The vehicle condition identified along the predetermined route may be referred to as a predictive vehicle condition, based on the predictive energy or power utilization of the battery pack along the predetermined route. Thus, the processing circuitry may be configured to predict one or more vehicle conditions along the predetermined route using the predictive energy or power utilization of the battery pack of the electric vehicle for the predetermined route, wherein the identified vehicle condition is comprised in the one or more predicted vehicle conditions.

Optionally in some examples, including in at least one preferred example, the processing circuitry is further configured to: in response of identifying a vehicle condition as regenerative limiting, set the fixed operating window of the battery pack according to the limited predetermined SOC limits in response of the determined health condition of the battery pack being below a first predetermined health condition threshold. A technical benefit may include limited deterioration of the health condition of the battery pack. Thus, the battery pack may be operated within the fixed operating window defined by the limited predetermined SOC limits in order to improve the health condition of the battery pack, at least compared to operating the battery pack by a fixed operating window defined by the default, or extended, predetermined SOC limits. The health condition of the battery pack may e.g. be defined by a value of between 0 and 100, where 0 is corresponding to a deteriorated battery pack (e.g. nonfunctional or at minimum health) and 100 is corresponding to no deterioration of the battery pack (i.e. a battery pack at maximum or full health, perfect condition). For example, the first predetermined health condition threshold may be set to a value between 20 and 30.

Optionally in some examples, including in at least one preferred example, the processing circuitry is further configured to: in response of identifying a vehicle condition as regenerative limiting, set the fixed operating window of the battery pack according to the extended predetermined SOC limits in response of the determined health condition of the battery pack being above a second predetermined health condition threshold. A technical benefit may include adapted (increased) energy availability and/or energy utilization by the extended predetermined SOC limits of the battery pack while reducing the risk of excessively reducing the battery pack health condition, or even while reducing the risk of battery pack failure due to battery health deterioration, e.g. below a set threshold. Thus, the battery pack may be operated within the fixed operating window defined by the extended predetermined SOC limits at the expense of deteriorating the health condition of the battery pack, at least compared to operating the battery pack by a fixed operating window defined by the default, or limited, predetermined SOC limits, as the battery pack health condition is above the second predetermined health condition threshold. For example, and with reference to the previously defined health condition between a value of between 0 and 100, the second predetermined health condition threshold may be set to a value between 70 and 80.

Optionally in some examples, including in at least one preferred example, the processing circuitry is further configured to: in response of identifying a vehicle condition as regenerative limiting, set the fixed operating window of the battery pack according to default predetermined SOC limits in response of the determined health condition of the battery pack being between the first predetermined health condition threshold and the second predetermined health condition threshold. A technical benefit may include adapted energy availability and/or energy utilization by the default predetermined SOC limits of the battery pack (e.g. increased as compared to the limited predetermined SOC limits) while reducing the risk of excessively reducing the battery pack health condition, or even while reducing the risk of battery pack failure due to battery health deterioration, e.g. below a set threshold. Thus, the battery pack may be operated within the fixed operating window defined by the default predetermined SOC limits while not causing excessive deterioration of the health condition of the battery pack, at least compared to operating the battery pack by a fixed operating window defined by the extended predetermined SOC limits, as the battery pack health condition is between the first and second predetermined health condition thresholds.

Optionally in some examples, including in at least one preferred example, the processing circuitry is further configured to: determine a driver profile for operating the electric vehicle along the predetermined route, and in response to the determined driver profile, adapt at least one of the first and second predetermined health condition thresholds. A technical benefit may include adapted energy availability and/or energy utilization by adapted first and/or second predetermined health condition thresholds while reducing the risk of excessively reducing the battery pack health condition, or even while reducing the risk of battery pack failure due to battery health deterioration, e.g. below a set threshold caused by driving the vehicle according to driver profile corresponding to a relatively high deterioration of the battery pack health condition (as compared to driving the vehicle according to driver profile corresponding to a relatively low deterioration of the battery pack health condition). For example, the driver profile may belong to a group of predefined driver profiles including light, moderate and heavy driving profiles. In some examples, the processing circuitry is configured to receive data of the driver profile from stored data comprised in a memory, e.g. a memory of the electric vehicle, or a memory of an external server database, typically in the form of a look-up table. The driver profile may typically be based on the driving history of the driver. Thus, the processing circuitry may be configured to identify the current driver profile as belonging to the group of predefined driver profiles, and identify the current driver profile as either a light, a moderate or a heavy driving profile. For example, in response of identifying the current driver profile as a light driving profile, the driving of the vehicle corresponds to a relatively low deterioration of the battery pack health condition as compared to the moderate and heavy driving profile, and hence the first and/or the second predetermined health condition threshold can be set less conservative as compared to when the current driver profile is identified as a moderate or a heavy driving profile. Correspondingly, in response of identifying the current driver profile as a moderate driving profile, the driving of the vehicle corresponds to a relatively low deterioration of the battery pack health condition as compared to the heavy driving profile, but not to the light driving profile, and hence the first and/or the second predetermined health condition threshold can be set less conservative as compared to when the current driver profile is identified as a heavy driving profile, but more conservative as compared to when the current driver profile is identified as a light driving profile. The current driver profile may be provided as user input data. For example, the processing circuitry may be configured to receive user input data including at least the predetermined route, the current driver profile, and e.g. a distance to a charging point arranged somewhere along the predetermined route, and additionally use such user input data when setting the fixed operating window of the battery pack.

Optionally in some examples, including in at least one preferred example, the processing circuitry is further configured to: identify a vehicle condition along the predetermined route as belonging to a group of predefined vehicle conditions defined as non-regenerative limiting, the non-regenerative limiting being defined as vehicle conditions in which charging of the battery pack by the regenerative braking system to its fully charged level do not occur anywhere along the predetermined route, and in response of identifying a vehicle condition as non-regenerative limiting, set the fixed operating window of the battery pack according to the limited predetermined SOC limits in response of the determined health condition of the battery pack being below the first predetermined health condition threshold. A technical benefit may include limited deterioration of the health condition of the battery pack. Thus, the battery pack may be operated within the fixed operating window defined by the limited predetermined SOC limits in order to improve the health condition of the battery pack, at least compared to operating the battery pack by a fixed operating window defined by the default, or extended, predetermined SOC limits, while accounting for the need of regenerative charging as the charging of the battery pack by the regenerative braking system to its fully charged level will not occur anywhere along the predetermined route. Thus, the energy availability and/or energy utilization of the battery pack is adapted by the limited predetermined SOC limits (e.g. decreased as compared to the default and extended predetermined SOC limits) for the benefit of reducing the risk of excessively reducing the battery pack health condition, or even while reducing the risk of battery pack failure due to battery health deterioration, e.g. below a set threshold. A technical benefit may also include efficient distinguishing between vehicle conditions being regenerative limiting and non-regenerative limiting. The group of predefined vehicle conditions defined as regenerative limiting and non-regenerative limiting may e.g. be stored in the previously mentioned memory, e.g. in the form of a look-up table.

Optionally in some examples, including in at least one preferred example, the processing circuitry is further configured to segmentize the predetermined route into predefined segments, wherein each predefined segment of the predetermined route is associated with a predicted vehicle condition. For example, the processing circuitry is further configured to associate each one of the predefined segments of the predetermined route with either regenerative limiting or non-regenerative limiting vehicle conditions. Thus, the predetermined route may be defined as regenerative limiting in response to that at least one of the predefined segments is associated with a regenerative limiting vehicle condition, and/or the predetermined route may be defined as non-regenerative limiting in response to that all of the predefined segments are associated with the non-regenerative limiting vehicle condition.

Optionally in some examples, including in at least one preferred example, the processing circuitry is further configured to: in response of identifying a vehicle condition as non-regenerative limiting, set the fixed operating window of the battery pack according to the default predetermined SOC limits in response of the determined health condition of the battery pack being above the first predetermined health condition threshold. A technical benefit may include adapted energy availability and/or energy utilization by the default predetermined SOC limits of the battery pack (e.g. increased as compared to the limited predetermined SOC limits) while reducing the risk of excessively reducing the battery pack health condition, or even while reducing the risk of battery pack failure due to battery health deterioration, e.g. below a set threshold. Thus, the battery pack may be operated within the fixed operating window defined by the default predetermined SOC limits while not causing excessive deterioration of the health condition of the battery pack, at least compared to operating the battery pack by a fixed operating window defined by the extended predetermined SOC limits, as the battery pack health condition is between the first and second predetermined health condition thresholds, while accounting for the need of regenerative charging as the charging of the battery pack by the regenerative braking system to its fully charged level will not occur anywhere along the predetermined route.

Optionally in some examples, including in at least one preferred example, the processing circuitry is further configured to: determine vehicle weight of the electric vehicle and altitude data of the predetermined route of the electric vehicle, and determine the battery pack charging by the regenerative braking system using the determined vehicle weight and altitude data. A technical benefit may include improved predictive energy or power utilization of the battery pack for the predetermined route. That is, the vehicle weight of the electric vehicle and the altitude data of the predetermined route are used as input to determine predicted energy or power utilization of the battery pack for the predetermined route. Thus, by using the vehicle weight of the electric vehicle and the altitude data of the predetermined route, the predictive energy or power utilization of the battery pack can be determined without complex calculations. Moreover, the previously mentioned predicted vehicle condition along the predetermined route can be more easily identified as a regenerative limiting or non-regenerative limiting vehicle condition. The processing circuitry may be configured to determine the vehicle weight by receiving weight data from a weight sensor, or by receiving weight data from stored data comprised in a memory, e.g. a memory of the electric vehicle, or a memory of an external server database, typically in the form of a look-up table. A technical benefit may include usage of reliable data and efficient handling and communication of data. The processing circuitry may be configured to determine altitude data of the predetermined route from stored data comprised in a memory, e.g. a memory of the electric vehicle, or a memory of an external server database. Alternatively, the processing circuitry is configured to receive topography data (e.g. from map data) of the predetermined route, and determine the altitude data in response of the topography data. A technical benefit may include usage of reliable data and efficient handling and communication of data.

Optionally in some examples, including in at least one preferred example, the processing circuitry is configured to determine predicted vehicle operational information, wherein the predicted energy or power utilization of the battery pack is determined using the predicted vehicle operational information. The predicted vehicle operational information may e.g. be based on historical, statistical, or scheduled data of the vehicle operation. The predicted vehicle operational information may comprise predicted operational load of the battery pack during the predicted vehicle operation of the electric vehicle. The predicted operational load of the battery pack is typically correlated to the altitude data. The predicted vehicle operational information may comprise predicted initialization time of operating the electric vehicle. In some examples, the predicted vehicle operational information comprises predicted operational load of the battery pack over time and along the predetermined route, such as e.g. during a drive cycle or a work/load cycle of the electric vehicle. Thus, the operating window of the battery pack may be set in accordance with, or in response to, at least the predicted operational load of the battery pack along the predetermined route. The predicted vehicle operational information, or the predicted operational load of the battery pack, may be used as input data to an energy or power utilization model.

Optionally in some examples, including in at least one preferred example, the processing circuitry is further configured to: determine the battery pack charging by power generation of the battery pack along the predetermined route using the battery pack regeneration equation 1 (as work in units Joule):

$$\text{Altitude change (m)} * \text{vehicle weight (kg)} * 9.81 \text{ (m/s2)} * \text{regeneration efficiency (1)}$$

The altitude change is thus determined by the altitude data of the predetermined route. The vehicle weight may be referred to as the mass of the vehicle and the regeneration efficiency of the vehicle is generally predetermined. Equation 1 can easily be transformed into the unit power (J/s) by applying it over a time interval.

Optionally in some examples, including in at least one preferred example, the predetermined route is defined to extend along a predefined path from a predefined starting position of the electric vehicle to a predefined destination, wherein the processing circuitry is further configured to: update the predetermined route and the setting of the fixed operating window of the battery pack according to either the limited SOC predetermined limits, the default predetermined SOC limits, or the extended predetermined SOC limits in response to a change in at least one of the predefined starting position, the predefined destination, and the predefined path. A technical benefit may include advantageous adaptation of the fixed operating window of the battery pack. Thus, in case the predetermined route is altered by the predefined starting position, the predefined destination, and/or the predefined path, the processing circuitry is configured to re-set the fixed operating window of the battery pack according to either the limited predetermined SOC limits, the default predetermined SOC limits, or the extended predetermined SOC limits.

Optionally in some examples, including in at least one preferred example, the predefined destination is a predefined charging destination providing external charging of the battery pack. A technical benefit may include a well-defined predetermined route for which the battery pack may be externally charged at the end of the predetermined route. The charging destination may e.g. be defined by providing charging from the electrical grid, e.g. the common electrical grid. The external charging of the battery pack may be defined by that the battery pack is charged from a power source externally of the vehicle, e.g. the electrical grid.

Optionally in some examples, including in at least one preferred example, the processing circuitry is configured to receive data of the predetermined route of the electric vehicle from stored data comprised in a memory, e.g. a memory of the electric vehicle, or a memory of an external server database. Such data may be provided as user-input data. For example, the user-input data may include a predetermined destination, and the predetermined route may be determined, by the processing circuitry, using map data and the predetermined destination. A technical benefit may include usage of reliable data and efficient handling and communication of data.

Optionally in some examples, including in at least one preferred example, the health condition of the battery pack is corresponding to the state-of-health, SOH, of the battery pack. A technical benefit may include an adequate parameter for determining the health condition of the battery pack. The SOH may e.g. be defined by the decline in energy and/or power capacity. For example, the SOH can be defined as the ratio of the maximum battery charge to its rated capacity: SOH (%) = 100 * Qmax / Cr, in which Qmax is the maximum charge available of the battery pack and Cr is the rated capacity. With reference to the previously mentioned first and second predetermined health condition thresholds, the first predetermined health condition threshold may be set to SOH = 50 %, and the second predetermined health condition threshold may be set to SOH = 85 %.

Optionally in some examples, including in at least one preferred example, the processing circuitry is further configured to: set the fixed operating window of the battery pack during operation of the vehicle. A technical benefit may include adaptive setting of the fixed operating window. Thus, the predictive energy or power utilization may be determined by battery pack discharging in response to power consumption of the battery pack from the current position of the electric vehicle to a predetermined destination along the predetermined route, and battery pack charging in response to power generation of the battery pack from the current position of the electric vehicle to a predetermined destination along the predetermined route using a regenerative braking system of the electric vehicle.

Optionally in some examples, including in at least one preferred example, the processing circuitry is further configured to: determine the default predetermined SOC limits to extend from a lower default SOC limit having a SOC-value between 15 % and 30 %, to an upper default SOC limit having a SOC-value between 65 % and 85 %. A technical benefit may include well-defined default predetermined SOC limits.

Optionally in some examples, including in at least one preferred example, the processing circuitry is further configured to: determine the extended predetermined SOC limits to extend from a lower extended SOC limit having a SOC-value between 5 % and 30 %, to an upper extended SOC limit having a SOC-value between 65 % and 95 %. A technical benefit may include well-defined default predetermined SOC limits. It should be understood that when stating that at least one of an upper limit and a lower limit is extended compared to a corresponding upper limit or lower limit of the default predetermined SOC limits, the upper limit is extended (higher) compared to the corresponding upper limit of the default predetermined SOC limits and/or the lower limit is extended (lower) compared to the corresponding lower limit of the default predetermined SOC limits.

Optionally in some examples, including in at least one preferred example, the processing circuitry is further configured to: determine the limited predetermined SOC limits extend from a lower extended SOC limit having a SOC-value between 15 % and 45 %, to an upper extended SOC limit having a SOC-value between 55 % and 85 %. A technical benefit may include well-defined default predetermined SOC limits. It should be understood that when stating that at least one of an upper limit and a lower limit is limited compared to a corresponding upper limit or lower limit of the default predetermined SOC limits, the upper limit is limited (lower) compared to the corresponding upper limit of the default predetermined SOC limits and/or the lower limit is limited (higher) compared to the corresponding lower limit of the default predetermined SOC limits.

Optionally in some examples, including in at least one preferred example, the extended predetermined SOC limits is defined by that only one of the upper limit and lower limit is extended compared to the corresponding upper limit and lower limit of the default predetermined SOC limits, e.g. by only that the upper limit is extended (higher) compared to the corresponding upper limit of the default predetermined SOC limits or that the lower limit is extended (lower) compared to the corresponding lower limit of the default predetermined SOC limits. Thus, the operating window defined by the extended predetermined SOC limits is wider than the operating window defined by the default predetermined SOC limits.

Optionally in some examples, including in at least one preferred example, the limited predetermined SOC limits is defined by that only one of the upper limit and lower limit is limited compared to the corresponding upper limit and lower limit of the default predetermined SOC limits, e.g. by only that the upper limit is limited (lower) compared to the corresponding upper limit of the default predetermined SOC limits or that the lower limit is limited (higher) compared to the corresponding lower limit of the default predetermined SOC limits. Thus, the operating window defined by the default predetermined SOC limits is wider than the operating window defined by the limited predetermined SOC limits.

Optionally in some examples, including in at least one preferred example, the limited predetermined SOC limits is always limited as compared to the extended predetermined SOC limits. For example, by that the upper limit of the extended predetermined SOC limits is extended (higher) compared to the corresponding upper limit of the limited predetermined SOC limits and/or that the lower limit is extended (lower) compared to the corresponding lower limit of the limited predetermined SOC limits.

Optionally in some examples, including in at least one preferred example, the processing circuitry is configured to prohibit concurrent operation of the battery pack by various predefined operating windows. For example, in case the batter pack is to be operated according to the default predetermined SOC limits, the processing circuitry is configured to prohibit operation of the battery pack according to the extended predetermined SOC limits. Correspondingly, in case the batter pack is to be operated according to the limited predetermined SOC limits, the processing circuitry is configured to prohibit operation of the battery pack according to the default, and extended predetermined SOC limits. In other words, when prevailing conditions and/or criteria are controlling the operation of the battery pack within a certain operating window defined by the associated predetermined SOC limits, operation of the battery pack within another operating window defined by other predetermined SOC limits is prohibited.

Optionally in some examples, including in at least one preferred example, the battery pack is comprised in a rechargeable energy storage system, RESS, of the electric vehicle. The battery pack is configured to be operated within at least a first predefined operating window defined by the default predetermined SOC limits, and by at least a second predefined operating window defined by the extended predetermined SOC limits, and by at least a third predefined operating window defined by the limited predetermined SOC limits. The RESS may comprise one or several battery packs connected in parallel, and each battery pack typically comprises a plurality of series-connected battery cells. The battery cells may be clustered into battery modules, wherein each battery pack comprises a plurality of series-connected battery modules.

Optionally in some examples, including in at least one preferred example, the processing circuitry is configured to set the fixed operating window of the battery pack according to default predetermined SOC limits, extended predetermined SOC limits or limited predetermined SOC limits in advance to the electric vehicle operating along the predetermined route. For example, the processing circuitry may be configured to set the fixed operating window according to default predetermined SOC limits, extended predetermined SOC limits or limited predetermined SOC limits along the whole predetermined route. That is, the operating window will be fixed for the operating of the electric vehicle along the predetermined route.

According to a second aspect of the disclosure, a vehicle comprising the computer system of the first aspect of the disclosure is provided. The second aspect of the disclosure may seek to solve the same problem as described for the first aspect of the disclosure. Thus, effects and features of the second aspect of the disclosure are largely analogous to those described above in connection with the first aspect of the disclosure. Examples and embodiments mentioned in relation to the first aspect of the disclosure are largely compatible with the second aspect of the disclosure, and vice versa.

According to a third aspect of the disclosure, a computer-implemented method is provided. The computer-implemented method comprising: determining, by a processing circuitry of a computer system, operating windows of a battery pack of an electric vehicle defined by its state-of-charge, SOC, according to default predetermined SOC limits, extended predetermined SOC limits in which at least one of an upper limit and a lower limit is extended compared to a corresponding upper limit or lower limit of the default predetermined SOC limits, and limited predetermined SOC limits in which at least one of an upper limit and a lower limit is more limited compared to the corresponding upper limit or lower limit of the default predetermined SOC limits; determining, by the processing circuitry, predictive energy or power utilization of the battery pack for a predetermined route, the predictive energy or power utilization being determined by battery pack discharging in response to power consumption of the battery pack along the predetermined route, and battery pack charging in response to power generation of the battery pack along the predetermined route using a regenerative braking system of the electric vehicle; determining, by the processing circuitry, a health condition of the battery pack; and in response to the determined health condition of the battery pack and the determined predictive energy or power utilization of the battery pack for the predetermined route, setting, by the processing circuitry, a fixed operating window of the battery pack according to either the limited SOC predetermined limits, the default predetermined SOC limits, or the extended predetermined SOC limits. The third aspect of the disclosure may seek to solve the same problem as described for the first aspect of the disclosure. Thus, effects and features of the third aspect of the disclosure are largely analogous to those described above in connection with the first aspect of the disclosure. Examples and embodiments mentioned in relation to the first aspect of the disclosure are largely compatible with the third aspect of the disclosure, and vice versa.

According to a fourth aspect of the disclosure, a computer program product comprising program code for performing, when executed by the processing circuitry, the method of the third aspect of the disclosure is provided. The fourth aspect of the disclosure may seek to solve the same problem as described for the first aspect of the disclosure. Thus, effects and features of the fourth aspect of the disclosure are largely analogous to those described above in connection with the first aspect of the disclosure. The processing circuitry may be that of the first aspect of the disclosure.

According to a fifth aspect of the disclosure, a non-transitory computer-readable storage medium comprising instructions, which when executed by the processing circuitry, cause the processing circuitry to perform the method of the third aspect of the disclosure is provided. The fifth aspect of the disclosure may seek to solve the same problem as described for the first aspect of the disclosure. Thus, effects and features of the fifth aspect of the disclosure are largely analogous to those described above in connection with the first aspect of the disclosure. The processing circuitry may be that of the first aspect of the disclosure.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

**FIG. 1** is an exemplary, partly schematic, side view of vehicle comprising a powertrain with a battery pack in a rechargeable energy storage system, RESS, and a computer system according to one example.
**FIG. 2** is a graph showing default, limited and extended predetermined SOC limits of a battery pack according to one example.
**FIG. 3** is a flowchart illustrating the actions or steps of a method according to one example.
**FIG. 4** is a schematic diagram of an exemplary computer system for implementing examples disclosed herein, according to one example.

## DETAILED DESCRIPTION

The detailed description set forth below provides information and examples of the disclosed technology with sufficient detail to enable those skilled in the art to practice the disclosure.

The disclosed technology may solve problems related to deteriorated health condition of the battery pack related to the choice of SOC operating window. The disclosed technology may provide preemptive actions for avoiding unnecessary deterioration of the health condition of the battery pack, and may include control of the deterioration of the health condition of the battery pack with regards to the choice of SOC operating window among a plurality of predefined SOC operating windows. Hence, the utilization of, and storing of, energy in the battery pack of the electric vehicle along a predefined route may be set differently depending on the health condition of the battery pack. By setting the operating window to a fixed operating window in response to the determined health condition of the battery pack and the determined predictive energy or power utilization of the battery pack for the predetermined route, deterioration of the health condition of the battery pack can be better controlled with regards to the utilization of the energy storage and/or energy utilization of the battery pack. A technical benefit may include improved energy and health management of the battery pack.

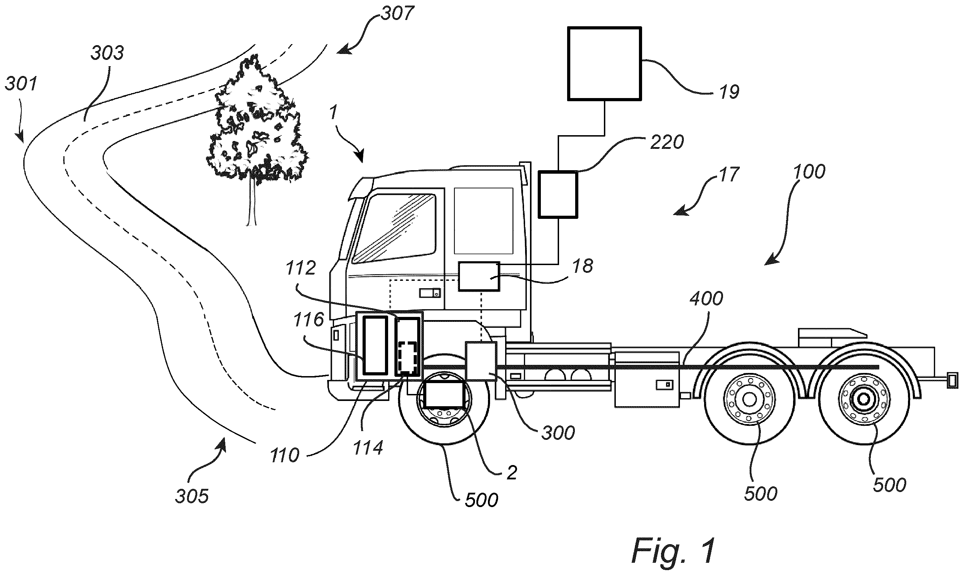

**FIG. 1** shows an exemplary electric vehicle 1 as a heavy duty truck 1. The electric vehicle 1 may be a full electric vehicle or a hybrid, comprising a powertrain 100 having an electric driveline 110 comprising a rechargeable energy storage system, RESS, 112 including at least one battery pack 114, and a at least one electric machine 116 powered by the battery pack 114. As seen in Fig. 1, the powertrain 100 may further comprise a transmission 300 comprising at least a gearbox, and drive shafts 400 configured to transfer motion to the drive wheels 500. The electric vehicle 1 typically comprises a regenerative braking system 2 of a known type. The regenerative braking system 2 generally comprises a kinetic energy recovery system configured to transfer kinetic energy of an object in motion, i.e. the electric vehicle 1, into stored energy, i.e. charging of the battery pack 114, to slow the electric vehicle 1 down. For example, the regenerative braking system 2 comprises an electric generator, which preferably is the same component as the previously mentioned electric machine 116. Thus, the energy produced when slowing the electric vehicle 1 down, typically by braking, is stored chemically in the battery pack 114 (i.e. regenerative charging of the battery pack 114, or simply battery regeneration). The battery regeneration of the regenerative braking system 2 is typically associated with a regeneration efficiency, i.e. how efficient the energy produced when slowing the electric vehicle 1 down is stored in the battery pack 114. In addition to the regenerative braking system 2, the electric vehicle 1 typically comprises service brakes of a known type, e.g. arranged to the two rear wheel axles.

The battery pack 114 is configured to be operated within predefined operating windows defined by its State-Of-Charge (SOC), according to default predetermined SOC limits, extended predetermined SOC limits in which at least one of an upper limit and a lower limit is extended compared to a corresponding upper limit or lower limit of the default predetermined SOC limits, and limited predetermined SOC limits in which at least one of an upper limit and a lower limit is more limited compared to the corresponding upper limit or lower limit of the default predetermined SOC limits.

The electric vehicle 1 further comprises computer system 17 comprising processing circuitry 18 configured to communicate with the batter pack 114 of the RESS 112. For example, the processing circuitry 18 may be configured to set a fixed operating window of the battery pack 114 according to the limited predetermined SOC limits, the default predetermined SOC limits, or the extended predetermined SOC limits, i.e. to operate the battery pack 114 according to either the limited predetermined SOC limits, the default predetermined SOC limits, or the extended predetermined SOC limits. The processing circuitry 18 is configured to communicate with a memory 19, e.g. a memory of the electric vehicle 1, or a memory of an external server database, and receive data 220 from the memory 19. The memory 19 may form part of the computer system 17.

The electric vehicle 1 may be scheduled to operate along a predetermined route 301. The predetermined route 301 is typically defined to extend along a predefined path 303 from a predefined starting position 305, e.g. the current position of the electric vehicle 1, to a predefined destination 307. The predefined destination 307 may e.g. be a predefined charging destination providing external charging of the battery pack 114.

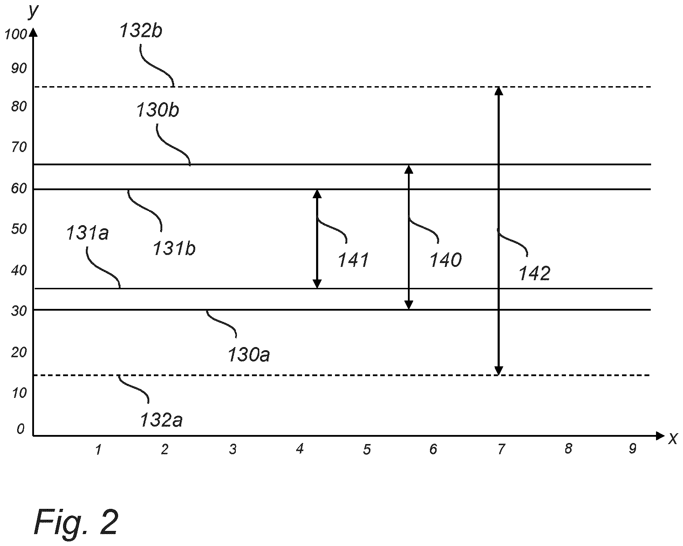

In the graph of **FIG. 2,** the y-axis represents the SOC of the battery pack 114 defined by a nominal SOC of 100 %, and the x-axis represents time (in units of e.g. minutes). The SOC may here be defined as the ratio of the available capacity $Q(t)$ and the maximum possible charge that can be stored in a battery, i.e., the nominal capacity $Q_n$, by $SOC(t) = Q(t)/Q_n$. A nominally fully charged level corresponds to a SOC 1 or 100% while a fully discharged level corresponds to a SOC of 0 or 0%. The available SOC of a battery pack 114 is typically limited within certain limits, or within predefined operating windows defined by SOC. Thus, the nominally fully charged level and the fully discharged level of the battery pack are typically not reached during operation of the electric vehicle 1. In the following such predefined operating windows will be described in more detail. For simplicity, the SOC values of the predefined operating windows are straight lines in Fig. 2, and are thus shown to be constant over the given time period (but they may alternatively vary over the given time period).

In the graph of Fig. 2, a default operating window 140 defined by default predetermined SOC limits 140 are defined to extend from a lower default SOC limit 130a having a SOC value of 30 %, to an upper default SOC limit 130b having a SOC value of 65 %. The default operating window 140 of the battery pack 114 in accordance with the lower and upper default predetermined SOC limits 130a, 130b is symbolized by a first double ended arrow 140. Thus, the battery pack 114 is configured to be operated within the predefined default operating window 140 according to the lower and upper default predetermined SOC limits 130a, 130b. Note that the nominal SOC of 100 % is not corresponding to the previously defined "fully charged level", the latter being defined by the upper limit 130b of the default operating window 140.

Moreover, in the graph of Fig. 2, an extended operating window 142 defined by extended predetermined SOC limits 142 are defined to extend from a lower extended SOC limit 132a having SOC value of 15 %, to an upper extended SOC limit 132b having SOC value of 85 %. The extended operating window 142 of the battery pack 114 in accordance with the lower and upper extended predetermined SOC limits 132a, 132b is symbolized by a second double ended arrow 142. Thus, the battery pack 114 is configured to be operated within the predefined extended operating window 142 according to the lower and upper extended predetermined SOC limits 132a, 132b. It should be noted that in the graph of Fig. 2, the upper default SOC limit 130b is set stricter (lower) than the corresponding upper extended SOC limit 132b, and the lower default SOC limit 130a is set stricter (higher) than the corresponding lower extended SOC limit 132a.

Moreover, in the graph of Fig. 2, a limited operating window 141 defined by limited predetermined SOC limits 141 are defined to extend from a lower limited SOC limit 131a having SOC value of 35 %, to an upper limited SOC limit 131b having SOC value of 60 %. The limited operating window 141 of the battery pack 114 in accordance with the lower and upper limited predetermined SOC limits 131a, 131b is symbolized by a third double ended arrow 141. Thus, the battery pack 114 is configured to be operated within the predefined limited operating window 141 according to the lower and upper limited predetermined SOC limits 131a, 131b. It should be noted that in the graph of Fig. 2, the upper limited SOC limit 131b is set stricter (lower) than the corresponding upper default SOC limit 130b (and lower than the corresponding upper default SOC limit 132b), and the lower limited SOC limit 1301 is set stricter (higher) than the corresponding lower default SOC limit 130a (and higher than the corresponding upper extended SOC limit 132a).

With additional reference to Fig. 1, the processing circuitry 18 is configured to determine operating windows 140, 141, 142 of the battery pack 114, such as the previously described default, extended and limited operating windows 140, 141, 142. The operating windows 140, 141, 142 may e.g. be accessed by received data 220 from the memory 19.

Moreover, the processing circuitry 18 is configured to determine predictive energy or power utilization of the battery pack 114 for the predetermined route 301. The predictive energy or power utilization is determined by battery pack discharging in response to power consumption of the battery pack 114 for operation of the electric vehicle 1 along the predetermined route 301, and battery pack charging in response to power generation of the battery pack 114 for operation of the electric vehicle 1 along the predetermined route 301 using the regenerative braking system 2, as previously described.

The processing circuitry 18 is further configured to determine a health condition of the battery pack 114. The health condition of the battery pack may e.g. be defined by a value of between 0 and 100, where 0 is corresponding to a deteriorated battery pack (e.g. nonfunctional or at minimum health) and 100 is corresponding to no deterioration of the battery pack (i.e. a battery pack at maximum or full health, perfect condition). For example, the health condition of the battery pack 114 may correspond to the state-of-health, SOH, of the battery pack 114.

The processing circuitry 18 is further configured to, in response to the determined health condition of the battery pack 114 and the determined predictive energy or power utilization of the battery pack 114 for the predetermined route 301, set a fixed operating window 140, 141, 142 of the battery pack 114 according to either the limited predetermined SOC limits 142, the default predetermined SOC limits 140, or the extended predetermined SOC limits 141.

For example, the processing circuitry 18 may be further configured to identify a vehicle condition along the predetermined route 301 as belonging to a group of predefined vehicle conditions defined as regenerative limiting, the regenerative limiting being defined as vehicle conditions in which charging of the battery pack 114 by the regenerative braking system 2 to its fully charged level occurs somewhere along the predetermined route 301. The fully charged level is here defined by the upper limit 130b of the default predetermined SOC limits 140, and not the nominal SOC of 100 %.

The processing circuitry 18 may be further configured to, in response of identifying a vehicle condition as regenerative limiting, set the fixed operating window 140, 141, 142 of the battery pack 114 according to the limited predetermined SOC limits 141 in response of the determined health condition of the battery pack 114 being below a first predetermined health condition threshold. Hereby, limited deterioration of the health condition of the battery pack 114 is achieved. Thus, the battery pack 114 may be operated within the fixed operating window 141 defined by the limited predetermined SOC limits along the predetermined route 301 in order to improve the health condition of the battery pack 114, at least compared to operating the battery pack 114 by a fixed operating window defined by the default, or extended, predetermined SOC limits 140, 142.

Additionally or alternatively, the processing circuitry 18 may be configured to, in response of identifying a vehicle condition as regenerative limiting, set the fixed operating window 140, 141, 142 of the battery pack 114 according to the extended predetermined SOC limits 142 in response of the determined health condition of the battery pack 114 being above a second predetermined health condition threshold. Hereby, adapted (increased) energy availability and/or energy utilization by the extended predetermined SOC limits 142 of the battery pack 114 is achieved while reducing the risk of excessively reducing the battery pack health condition, or even while reducing the risk of battery pack failure due to battery health deterioration, e.g. below a set threshold. Thus, the battery pack 114 may be operated within the fixed operating window defined by the extended predetermined SOC limits 142 along the predetermined route 301 at the expense of deteriorating the health condition of the battery pack 114, at least compared to operating the battery pack 114 by a fixed operating window defined by the default, or limited, predetermined SOC limits 140, 141, as the battery pack health condition is above the second predetermined health condition threshold.

Additionally or alternatively, the processing circuitry 18 may be configured to, in response of identifying a vehicle condition as regenerative limiting, set the fixed operating window 140, 141, 142 of the battery pack 114 according to default predetermined SOC limits 140 in response of the determined health condition of the battery pack 114 being between the first predetermined health condition threshold and the second predetermined health condition threshold. Hereby, adapted energy availability and/or energy utilization by the default predetermined SOC limits 140 of the battery pack 114 (e.g. increased as compared to the limited predetermined SOC limits 141) is achieved while reducing the risk of excessively reducing the battery pack health condition, or even while reducing the risk of battery pack failure due to battery health deterioration, e.g. below a set threshold. Thus, the battery pack 114 may be operated within the fixed operating window 140 defined by the default predetermined SOC limits along the predetermined route 301 while not causing excessive deterioration of the health condition of the battery pack 114, at least compared to operating the battery pack 114 by a fixed operating window defined by the extended predetermined SOC limits 142, as the battery pack health condition is between the first and second predetermined health condition thresholds.

The processing circuitry 18 may be further configured to determine a driver profile for operating the electric vehicle 1 along the predetermined route 301, and in response to the determined driver profile, adapt at least one of the first and second predetermined health condition thresholds. Thus, adapted energy availability and/or energy utilization by adapted first and/or second predetermined health condition thresholds is achieved while reducing the risk of excessively reducing the battery pack health condition, or even while reducing the risk of battery pack failure due to battery health deterioration, e.g. below a set threshold caused by driving the vehicle 1 according to driver profile corresponding to a relatively high deterioration of the battery pack health condition (as compared to driving the vehicle 1 according to driver profile corresponding to a relatively low deterioration of the battery pack health condition). For example, the driver profile may belong to a group of predefined driver profiles including light, moderate and heavy driving profiles. In some examples, the processing circuitry is configured to receive data 220 of the driver profile from the memory 19, typically in the form of a look-up table.

The processing circuitry 18 may be further configured to identify a vehicle condition along the predetermined route 301 as belonging to a group of predefined vehicle conditions defined as non-regenerative limiting, the non-regenerative limiting being defined as vehicle conditions in which charging of the battery pack 114 by the regenerative braking system 2 to its fully charged level do not occur anywhere along the predetermined route 301, and in response of identifying a vehicle condition as non-regenerative limiting, set the fixed operating window 140, 141, 142 of the battery pack 114 according to the limited predetermined SOC limits 141 in response of the determined health condition of the battery pack 114 being below the first predetermined health condition threshold. Hereby, limited deterioration of the health condition of the battery pack 114 is achieved. Thus, the battery pack 114 may be operated within the fixed operating window defined by the limited predetermined SOC limits 141 along the predetermined route 301 in order to improve the health condition of the battery pack 114, at least compared to operating the battery pack 114 by a fixed operating window defined by the default, or extended, predetermined SOC limits 140, 142, while accounting for the need of regenerative charging as the charging of the battery pack 114 by the regenerative braking system 2 to its fully charged level will not occur anywhere along the predetermined route 301. Thus, the energy availability and/or energy utilization of the battery pack 114 is adapted by the limited predetermined SOC limits 141 (e.g. decreased as compared to the default and extended predetermined SOC limits 140, 142) for the benefit of reducing the risk of excessively reducing the battery pack health condition, or even while reducing the risk of battery pack failure due to battery health deterioration, e.g. below a set threshold.

Moreover, the processing circuitry 18 may be further configured to, in response of identifying a vehicle condition as non-regenerative limiting, set the fixed operating window 140, 141, 142 of the battery pack 114 according to the default predetermined SOC limits 140 in response of the determined health condition of the battery pack 114 being above the first predetermined health condition threshold. Hereby, adapted energy availability and/or energy utilization by the default predetermined SOC limits 140 of the battery pack 114 (e.g. increased as compared to the limited predetermined SOC limits 141) is achieved while reducing the risk of excessively reducing the battery pack health condition, or even while reducing the risk of battery pack failure due to battery health deterioration, e.g. below a set threshold. Thus, the battery pack 114 may be operated within the fixed operating window defined by the default predetermined SOC limits 140 along the predetermined route 301 while not causing excessive deterioration of the health condition of the battery pack 114, at least compared to operating the battery pack 114 by a fixed operating window defined by the extended predetermined SOC limits 142, as the battery pack health condition is between the first and second predetermined health condition thresholds, while accounting for the need of regenerative charging as the charging of the battery pack 114 by the regenerative braking system 2 to its fully charged level will not occur anywhere along the predetermined route 301.

The processing circuitry 18 may be further configured to determine vehicle weight of the electric vehicle 1 and altitude data of the predetermined route 301 of the electric vehicle 1, and determine the battery pack charging by the regenerative braking system 2 using the determined vehicle weight and altitude data. Moreover, the processing circuitry 18 may include the regeneration efficiency of the regenerative braking system 2 in the determination of the battery pack charging by the regenerative braking system 2 along the predetermined route 301. For example, the processing circuitry 18 may be configured to determine the battery pack charging by power generation of the battery pack along the predetermined route 301 using the battery pack regeneration equation 1 (as work in units Joule):

$$\text{Altitude change (m)} * \text{vehicle weight (kg)} * 9.81 \text{ (m/s2)} * \text{regeneration efficiency (1)}$$

The altitude change is thus determined by the altitude data of the predetermined route 301. The vehicle weight may be referred to as the mass of the vehicle 1 and the regeneration efficiency of the vehicle is generally predetermined. Equation 1 can easily be transformed into the unit power (J/s) by applying it over a time interval.

The processing circuitry 18, may e.g. be configured to utilize an energy or power utilization model for determining predictive energy or power utilization of the battery pack 114 of the electric vehicle 1 for the predetermined route. The energy or power utilization model typically uses the vehicle weight and altitude data of the predetermined route 301 as input data, and provides output data in the form of predictive energy or power utilization of the battery pack 114 for the predetermined route 301, and/or output data in the form of identification of a vehicle condition as regenerative limiting, or non-regenerative limiting, along the predetermined route 301. The predictive energy or power utilization of the battery pack 114 of the electric vehicle 1 for the predetermined route 301 may be determined by using the default predetermined SOC limits 140 of the battery pack 114. Thus, the energy or power utilization model may use the default predetermined SOC limits 140 of the battery pack 114 for determining the predictive energy or power utilization of the battery pack 114.

The processing circuitry 18 may be further configured to update the predetermined route 301 and the setting of the fixed operating window of the battery pack 114 according to either the limited SOC predetermined limits 141, the default predetermined SOC limits 140, or the extended predetermined SOC limits 142 in response to a change in at least one of the predefined starting position 305, the predefined destination 307, and the predefined path 303. For example, the processing circuitry 18 may be further configured to update the predetermined route 301 in response to a receiving a new predefined destination 307, such as e.g. a new predefined charging destination providing external charging of the battery pack 114. Additionally or alternatively, the processing circuitry 18 may be configured to set the fixed operating window 140, 141, 142 of the battery pack 114 during operation of the vehicle 1. For example, the update the predetermined route 301 in response to a change in at least one of the predefined starting position 305, the predefined destination 307, and the predefined path 303 may be performed during operation of the vehicle 1.

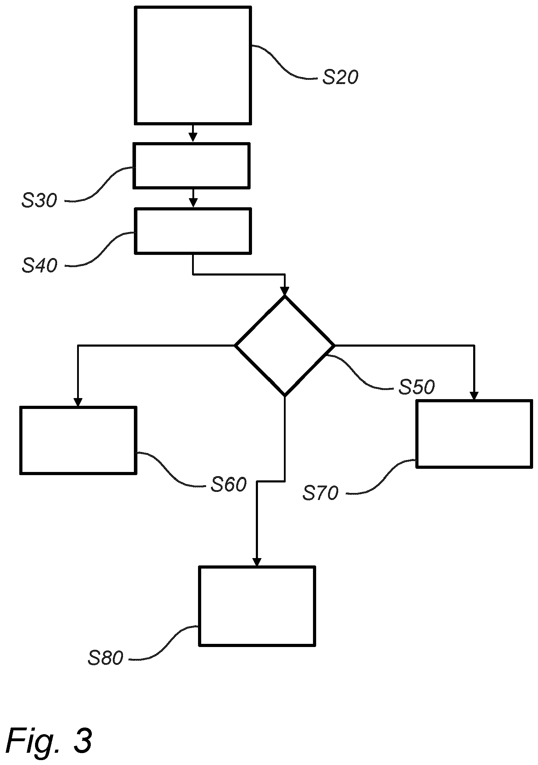

FIG. 3 is a flow chart of a computer implemented method for controlling the operating window of a battery pack defined by its SOC, such as battery pack 114 of RESS 112 of truck 1 in Fig. 1, according to one example. Thus, further reference is made with regards to Figs. 1 and 2.

In an action or step S20, e.g. being a first action or step S20, the operating window of the battery pack 114 defined by its SOC is determined by a processing circuitry of a computer system. For example, and with reference to Fig. 1, the processing circuitry 18 may be comprised in the computer system 17 of the electric vehicle 1. The operating windows determined by the processing circuitry 18 are typically those described with reference to Fig. 2, i.e. according to default predetermined SOC limits 140, extended predetermined SOC limits 142 in which at least one of an upper limit 132b and a lower limit 132a is extended compared to a corresponding upper limit 130b or lower limit 130a of the default predetermined SOC limits 140, and limited predetermined SOC limits 141 in which at least one of an upper limit 131b and a lower limit 131a is more limited compared to the corresponding upper limit 130b or lower limit 130a of the default predetermined SOC limits 140.

In an action or step S30, e.g. being a second action or step S30, predictive energy or power utilization of the battery pack 114 is determined by the processing circuitry 18 for a predetermined route 301, the predictive energy or power utilization being determined by battery pack discharging in response to power consumption of the battery pack 114 along the predetermined route 301, and battery pack charging in response to power generation of the battery pack 114 along the predetermined route 301 using a regenerative braking system 2 of the electric vehicle 1.

In an action or step S40, e.g. being a third action or step S40, a health condition of the battery pack 114 is determined by the processing circuitry 18. For example, the health condition is, or corresponds to, the SOH of the battery pack 114. It should be noted that action or step S30 and action or step S40 may be performed simultaneously, or in a different order as presented here.

In a decision making action or step S50, e.g. a fourth action or step S50 occurring subsequent to action or steps S20, S30, S40, the determined health condition of the battery pack 114 and the determined predictive energy or power utilization of the battery pack 114 for the predetermined route 301 are evaluated with regards to predetermined criteria, e.g. the determined health condition of the battery pack is compared to predetermined thresholds of the health condition of the battery pack 114, and the determined predictive energy or power utilization of the battery pack 114 is compared to predefined predicted vehicle conditions along the predetermined route 301, such as the previously mentioned regenerative-limiting and non-regenerative limiting vehicle conditions.

In an action or step S60, e.g. a sixth action or step S60, a fixed operating window 141 of the battery pack 114 is set by the processing circuitry 18 to the limited SOC predetermined limits 141 in response to the outcome of the decision making step S50, i.e. in response to the determined health condition of the battery pack 114 and the determined predictive energy or power utilization of the battery pack 114 for the predetermined route 301.

In an action or step S70, e.g. a seventh action or step S70 occurring instead of action or step S60, a fixed operating window 142 of the battery pack 114 is set by the processing circuitry 18 to the extended SOC predetermined limits 142 in response to the outcome of the decision making step S50, i.e. in response to the determined health condition of the battery pack 114 and the determined predictive energy or power utilization of the battery pack 114 for the predetermined route 301.

In an action or step S80, e.g. an eight action or step S80 occurring instead of action or step S60 and S70, a fixed operating window 140 of the battery pack 114 is set by the processing circuitry 18 to the default SOC predetermined limits 140 in response to the outcome of the decision making step S50, i.e. in response to the determined health condition of the battery pack 114 and the determined predictive energy or power utilization of the battery pack 114 for the predetermined route 301.

Thus, depending on the outcome of the decision making step S50, the operation of the battery pack 114 is either in accordance with action or step S60, S70 or S80.

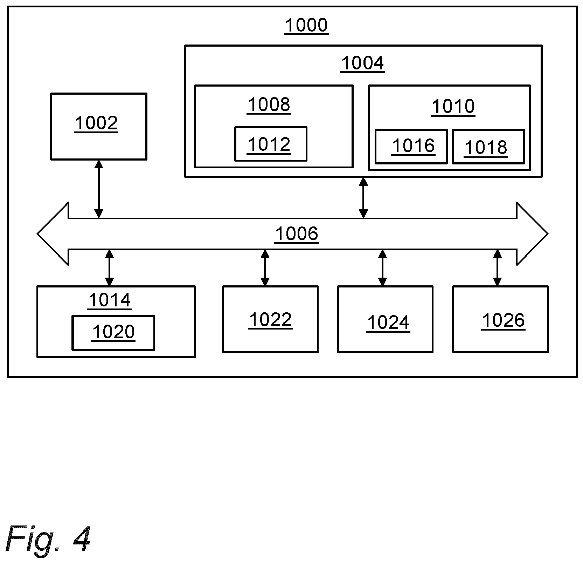

The processing circuitry 18 of Fig. 1 may be configured to perform the method as described with reference to Fig. 3. The method as described with reference to Fig. 3 may thus be implemented in a computer program product comprising program code for performing, when executed by the processing circuitry 18, the method described with reference to Fig. 3. Alternatively the method as described with reference to Fig. 3 may be implemented in a non-transitory computer-readable storage medium comprising instructions, which when executed by the processing circuitry 18, cause the processing circuitry 18 to perform the method as described with reference to Fig. 3. Thus, the processing circuitry 18 may comprise instructions to cause the powertrain 100 (e.g. the battery pack 114) to be operated according to at least some of the steps described with reference to Fig. 3. The processing circuitry 18 of the electric vehicle 1 of Fig. 1 may constitute, or be comprised in, a computer system 17 comprising one or more control units configured to perform the method as described with reference to Fig. 3 (e.g. one or more ECUs). Such computer system 17 is now exemplified with reference to Fig. 4.

**FIG. 4** is a schematic diagram of a computer system 1000 for implementing examples disclosed herein, e.g. the method as described with reference to Fig. 3. The computer system 1000 may correspond to, or be implemented in, the computer system 17 of Fig. 2. The computer system 1000 is adapted to execute instructions from a computer-readable medium to perform these and/or any of the functions or processing described herein. The computer system 1000 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 1000 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 1000 may comprise at least one computing device or electronic device capable of including firmware, hardware, and/or executing software instructions to implement the functionality described herein. The computer system 1000 may include a processing circuitry 1002 (e.g., processing circuitry including one or more processor devices or control units; e.g. corresponding to the processing circuitry 18 of Fig. 2), a memory 1004, and a system bus 1006. The computer system 1000 may include at least one computing device having the processing circuitry 1002. The system bus 1006 provides an interface for system components including, but not limited to, the memory 1004 and the processing circuitry 1002. The processing circuitry 1002 may include any number of hardware components for conducting data or signal processing or for executing computer code stored in memory 1004. The processing circuitry 1002 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 1002 may further include computer executable code that controls operation of the programmable device.

The system bus 1006 may be any of several types of bus structures that may further interconnect to a memory bus (with or without a memory controller), a peripheral bus, and/or a local bus using any of a variety of bus architectures. The memory 1004 may be one or more devices for storing data and/or computer code for completing or facilitating methods described herein. The memory 1004 may include database components, object code components, script components, or other types of information structure for supporting the various activities herein. Any distributed or local memory device may be utilized with the systems and methods of this description. The memory 1004 may be communicably connected to the processing circuitry 1002 (e.g., via a circuit or any other wired, wireless, or network connection) and may include computer code for executing one or more processes described herein. The memory 1004 may include non-volatile memory 1008 (e.g., read-only memory (ROM), erasable programmable read-only memory (EPROM), electrically erasable programmable read-only memory (EEPROM), etc.), and volatile memory 1010 (e.g., random-access memory (RAM)), or any other medium which can be used to carry or store desired program code in the form of machine-executable instructions or data structures and which can be accessed by a computer or other machine with a processing circuitry 1002. A basic input/output system (BIOS) 1012 may be stored in the non-volatile memory 1008 and can include the basic routines that help to transfer information between elements within the computer system 1000.

The computer system 1000 may further include or be coupled to a non-transitory computer-readable storage medium such as the storage device 1014, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 1014 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 1014 and/or in the volatile memory 1010, which may include an operating system 1016 and/or one or more program modules 1018. All or a portion of the examples disclosed herein may be implemented as a computer program 1020 stored on a transitory or non-transitory computer-usable or computer-readable storage medium (e.g., single medium or multiple media), such as the storage device 1014, which includes complex programming instructions (e.g., complex computer-readable program code) to cause the processing circuitry 1002 to carry out actions described herein. Thus, the computer-readable program code of the computer program 1020 can comprise software instructions for implementing the functionality of the examples described herein when executed by the processing circuitry 1002. In some examples, the storage device 1014 may be a computer program product (e.g., readable storage medium) storing the computer program 1020 thereon, where at least a portion of a computer program 1020 may be loadable (e.g., into a processor) for implementing the functionality of the examples described herein when executed by the processing circuitry 1002. The processing circuitry 1002 may serve as a controller or control system for the computer system 1000 that is to implement the functionality described herein.

The computer system 1000 may include an input device interface 1022 configured to receive input and selections to be communicated to the computer system 1000 when executing instructions, such as from a keyboard, mouse, touch-sensitive surface, etc. Such input devices may be connected to the processing circuitry 1002 through the input device interface 1022 coupled to the system bus 1006 but can be connected through other interfaces, such as a parallel port, an Institute of Electrical and Electronic Engineers (IEEE) 1394 serial port, a Universal Serial Bus (USB) port, an IR interface, and the like. The computer system 1000 may include an output device interface 1024 configured to forward output, such as to a display, a video display unit (e.g., a liquid crystal display (LCD) or a cathode ray tube (CRT)). The computer system 1000 may include a communications interface 1026 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1. A computer system comprising processing circuitry configured to: determine operating windows of a battery pack of an electric vehicle defined by its state-of-charge, SOC, according to default predetermined SOC limits, extended predetermined SOC limits in which at least one of an upper limit and a lower limit is extended compared to a corresponding upper limit or lower limit of the default predetermined SOC limits, and limited predetermined SOC limits in which at least one of an upper limit and a lower limit is more limited compared to the corresponding upper limit or lower limit of the default predetermined SOC limits; determine predictive energy or power utilization of the battery pack for a predetermined route, the predictive energy or power utilization being determined by battery pack discharging in response to power consumption of the battery pack along the predetermined route, and battery pack charging in response to power generation of the battery pack along the predetermined route using a regenerative braking system of the electric vehicle; determine a health condition of the battery pack; and in response to the determined health condition of the battery pack and the determined predictive energy or power utilization of the battery pack for the predetermined route, set a fixed operating window of the battery pack according to either the limited predetermined SOC limits, the default predetermined SOC limits, or the extended predetermined SOC limits.

Example 2. The computer system of example 1, wherein the processing circuitry is further configured to: identify a vehicle condition along the predetermined route as belonging to a group of predefined vehicle conditions defined as regenerative limiting, the regenerative limiting being defined as vehicle conditions in which charging of the battery pack by the regenerative braking system to its fully charged level occurs somewhere along the predetermined route, the fully charged level being set by the upper limit of the default predetermined SOC limits.

Example 3. The computer system of example 2, wherein the processing circuitry is further configured to: in response of identifying a vehicle condition as regenerative limiting, set the fixed operating window of the battery pack according to the limited predetermined SOC limits in response of the determined health condition of the battery pack being below a first predetermined health condition threshold.

Example 4. The computer system of any one of examples 2-3, wherein the processing circuitry is further configured to: in response of identifying a vehicle condition as regenerative limiting, set the fixed operating window of the battery pack according to the extended predetermined SOC limits in response of the determined health condition of the battery pack being above a second predetermined health condition threshold.

Example 5. The computer system of examples 3 and 4, wherein the processing circuitry is further configured to: in response of identifying a vehicle condition as regenerative limiting, set the fixed operating window of the battery pack according to default predetermined SOC limits in response of the determined health condition of the battery pack being between the first predetermined health condition threshold and the second predetermined health condition threshold.

Example 6. The computer system of any one examples 4-5, wherein the processing circuitry is further configured to: determine a driver profile for operating the electric vehicle along the predetermined route, and in response to the determined driver profile, adapt at least one of the first and second predetermined health condition thresholds.

Example 7. The computer system of any one of examples 1-6, wherein the processing circuitry is further configured to: identify a vehicle condition along the predetermined route as belonging to a group of predefined vehicle conditions defined as non-regenerative limiting, the non-regenerative limiting being defined as vehicle conditions in which charging of the battery pack by the regenerative braking system to its fully charged level do not occur anywhere along the predetermined route, and in response of identifying a vehicle condition as non-regenerative limiting, set the fixed operating window of the battery pack according to the limited predetermined SOC limits in response of the determined health condition of the battery pack being below the first predetermined health condition threshold.

Example 8. The computer system of example 7, wherein the processing circuitry is further configured to: in response of identifying a vehicle condition as non-regenerative limiting, set the fixed operating window of the battery pack according to the default predetermined SOC limits in response of the determined health condition of the battery pack being above the first predetermined health condition threshold.

Example 9. The computer system of any of examples 1-8, wherein the processing circuitry is further configured to: determine vehicle weight of the electric vehicle and altitude data of the predetermined route of the electric vehicle, and determine the battery pack charging by the regenerative braking system using the determined vehicle weight and altitude data.

Example 10. The computer system of any of examples 1-9, wherein the predetermined route is defined to extend along a predefined path from a predefined starting position of the electric vehicle to a predefined destination, wherein the processing circuitry is further configured to: update the predetermined route and the setting of the fixed operating window of the battery pack according to either the limited SOC predetermined limits, the default predetermined SOC limits, or the extended predetermined SOC limits in response to a change in at least one of the predefined starting position, the predefined destination, and the predefined path.

Example 11. The computer system of example 10, wherein the predefined destination is a predefined charging destination providing external charging of the battery pack.

Example 12. The computer system of any one of the preceding examples, wherein the health condition of the battery pack is corresponding to the state-of-health, SOH, of the battery pack.

Example 13. The computer system of any one of the preceding examples, wherein the processing circuitry is further configured to: set the fixed operating window of the battery pack during operation of the vehicle.

Example 14. The computer system of any one of the preceding examples, wherein the processing circuitry is further configured to: determine the default predetermined SOC limits to extend from a lower default SOC limit having a SOC-value between 15 % and 30 %, to an upper default SOC limit having a SOC-value between 65 % and 85 %.

Example 15. The computer system of any one of the preceding examples, wherein the processing circuitry is further configured to: determine the extended predetermined SOC limits to extend from a lower extended SOC limit having a SOC-value between 5 % and 30 %, to an upper extended SOC limit having a SOC-value between 65 % and 95 %.

Example 16. The computer system of any one of the preceding examples, wherein the processing circuitry is further configured to: determine the limited predetermined SOC limits extend from a lower extended SOC limit having a SOC-value between 15 % and 45 %, to an upper extended SOC limit having a SOC-value between 55 % and 85 %.

Example 17. A vehicle comprising the computer system of any of examples 1-17.

Example 18. A computer-implemented method, comprising: determining, by a processing circuitry of a computer system, operating windows of a battery pack of an electric vehicle defined by its state-of-charge, SOC, according to default predetermined SOC limits, extended predetermined SOC limits in which at least one of an upper limit and a lower limit is extended compared to a corresponding upper limit or lower limit of the default predetermined SOC limits, and limited predetermined SOC limits in which at least one of an upper limit and a lower limit is more limited compared to the corresponding upper limit or lower limit of the default predetermined SOC limits; determining, by the processing circuitry, predictive energy or power utilization of the battery pack for a predetermined route, the predictive energy or power utilization being determined by battery pack discharging in response to power consumption of the battery pack along the predetermined route, and battery pack charging in response to power generation of the battery pack along the predetermined route using a regenerative braking system of the electric vehicle; determining, by the processing circuitry, a health condition of the battery pack; and in response to the determined health condition of the battery pack and the determined predictive energy or power utilization of the battery pack for the predetermined route, setting, by the processing circuitry, a fixed operating window of the battery pack according to either the limited SOC predetermined limits, the default predetermined SOC limits, or the extended predetermined SOC limits.

Example 19. A computer program product comprising program code for performing, when executed by the processing circuitry, the method of example 18.

Example 20. A non-transitory computer-readable storage medium comprising instructions, which when executed by the processing circuitry, cause the processing circuitry to perform the method of example 18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1. A computer system (17) comprising processing circuitry (18) configured to:

   - determine operating windows (140, 141, 142) of a battery pack (114) of an electric vehicle (1) defined by its state-of-charge, SOC, according to default predetermined SOC limits (140), extended predetermined SOC limits (142) in which at least one of an upper limit (132b) and a lower limit (132a) is extended compared to a corresponding upper limit (130b) or lower limit (130a) of the default predetermined SOC limits (140), and limited predetermined SOC limits (141) in which at least one of an upper limit (131b) and a lower limit (131a) is more limited compared to the corresponding upper limit (130b) or lower limit (130a) of the default predetermined SOC limits (140);
   - determine predictive energy or power utilization of the battery pack (114) for a predetermined route (301), the predictive energy or power utilization being determined by battery pack discharging in response to power consumption of the battery pack (114) along the predetermined route (301), and battery pack charging in response to power generation of the battery pack (114) along the predetermined route (301) using a regenerative braking system (2) of the electric vehicle (1);
   - determine a health condition of the battery pack (114); and
   - in response to the determined health condition of the battery pack (114) and the determined predictive energy or power utilization of the battery pack (114) for the predetermined route (301), set a fixed operating window (140, 141, 142) of the battery pack (114) according to either the limited predetermined SOC limits (142), the default predetermined SOC limits (140), or the extended predetermined SOC limits (141).

2. The computer system (17) of claim 1, wherein the processing circuitry (18) is further configured to: identify a vehicle condition along the predetermined route (301) as belonging to a group of predefined vehicle conditions defined as regenerative limiting, the regenerative limiting being defined as vehicle conditions in which charging of the battery pack (114) by the regenerative braking system (2) to its fully charged level occurs somewhere along the predetermined route (301), the fully charged level being set by the upper limit (130b) of the default predetermined SOC limits (140).

3. The computer system (17) of claim 2, wherein the processing circuitry (18) is further configured to: in response of identifying a vehicle condition as regenerative limiting, set the fixed operating window (140, 141, 142) of the battery pack (114) according to the limited predetermined SOC limits (141) in response of the determined health condition of the battery pack (114) being below a first predetermined health condition threshold.

4. The computer system (17) of any one of claims 2-3, wherein the processing circuitry (18) is further configured to: in response of identifying a vehicle condition as regenerative limiting, set the fixed operating window (140, 141, 142) of the battery pack (114) according to the extended predetermined SOC limits (142) in response of the determined health condition of the battery pack (114) being above a second predetermined health condition threshold.

5. The computer system (17) of claims 3 and 4, wherein the processing circuitry (18) is further configured to: in response of identifying a vehicle condition as regenerative limiting, set the fixed operating window (140, 141, 142) of the battery pack (114) according to default predetermined SOC limits (140) in response of the determined health condition of the battery pack (114) being between the first predetermined health condition threshold and the second predetermined health condition threshold.

6. The computer system (17) of any one claims 4-5, wherein the processing circuitry (18) is further configured to: determine a driver profile for operating the electric vehicle (1) along the predetermined route (301), and in response to the determined driver profile, adapt at least one of the first and second predetermined health condition thresholds.

7. The computer system (17) of any one of claims 1-6, wherein the processing circuitry (18) is further configured to: identify a vehicle condition along the predetermined route (301) as belonging to a group of predefined vehicle conditions defined as non-regenerative limiting, the non-regenerative limiting being defined as vehicle conditions in which charging of the battery pack (114) by the regenerative braking system (2) to its fully charged level do not occur anywhere along the predetermined route (301), and in response of identifying a vehicle condition as non-regenerative limiting, set the fixed operating window (140, 141, 142) of the battery pack (114) according to the limited predetermined SOC limits (141) in response of the determined health condition of the battery pack (114) being below the first predetermined health condition threshold.

8. The computer system (17) of claim 7, wherein the processing circuitry (18) is further configured to: in response of identifying a vehicle condition as non-regenerative limiting, set the fixed operating window (140, 141, 142) of the battery pack (114) according to the default predetermined SOC limits (140) in response of the determined health condition of the battery pack (114) being above the first predetermined health condition threshold.

9. The computer system (17) of any of claims 1-8, wherein the processing circuitry (18) is further configured to: determine vehicle weight of the electric vehicle (1) and altitude data of the predetermined route (301) of the electric vehicle (1), and determine the battery pack charging by the regenerative braking system (2) using the determined vehicle weight and altitude data.

10. The computer system (17) of any of claims 1-9, wherein the predetermined route (301) is defined to extend along a predefined path (303) from a predefined starting position (305) of the electric vehicle (1) to a predefined destination (307), wherein the processing circuitry (18) is further configured to: update the predetermined route (301) and the setting of the fixed operating window of the battery pack (114) according to either the limited SOC predetermined limits (141), the default predetermined SOC limits (140), or the extended predetermined SOC limits (142) in response to a change in at least one of the predefined starting position (305), the predefined destination (307), and the predefined path (303).

11. The computer system (17) of any one of the preceding claims, wherein the health condition of the battery pack (114) is corresponding to the state-of-health, SOH, of the battery pack (114).

12. A vehicle (1) comprising the computer system (17) of any of claims 1-11.

13. A computer-implemented method, comprising:

- determining (S20), by a processing circuitry (18) of a computer system (17), operating windows (140, 141, 142) of a battery pack (114) of an electric vehicle (1) defined by its state-of-charge, SOC, according to default predetermined SOC limits (140), extended predetermined SOC limits (142) in which at least one of an upper limit (132b) and a lower limit (132a) is extended compared to a corresponding upper limit (130b) or lower limit (130a) of the default predetermined SOC limits (140), and limited predetermined SOC limits (141) in which at least one of an upper limit (131b) and a lower limit (131a) is more limited compared to the corresponding upper limit (130b) or lower limit (130a) of the default predetermined SOC limits (140);
- determining (S30), by the processing circuitry (18), predictive energy or power utilization of the battery pack (114) for a predetermined route (301), the predictive energy or power utilization being determined by battery pack discharging in response to power consumption of the battery pack (114) along the predetermined route (301), and battery pack charging in response to power generation of the battery pack (114) along the predetermined route

(301) using a regenerative braking system (2) of the electric vehicle (1);
- determining (S40), by the processing circuitry (18), a health condition of the battery pack (114); and
- in response to the determined health condition of the battery pack (114) and the determined predictive energy or power utilization of the battery pack (114) for the predetermined route (301), setting (S60, S70, S80), by the processing circuitry (18), a fixed operating window (140, 141, 142) of the battery pack (114) according to either the limited SOC predetermined limits (141), the default predetermined SOC limits (140), or the extended predetermined SOC limits (142).

14. A computer program product comprising program code for performing, when executed by the processing circuitry, the method of claim 13.

15. A non-transitory computer-readable storage medium comprising instructions, which when executed by the processing circuitry, cause the processing circuitry to perform the method of claim 13.

Fig. 1

Fig. 2

*Fig. 3*

Fig. 4

# EUROPEAN SEARCH REPORT

**Application Number**

EP 24 18 1711

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/368481 A1 (NUBER JOHANNES [DE] ET AL) 22 December 2016 (2016-12-22) | 1-15 | INV.<br>B60L3/00 |
| Y | * paragraph [0078] - paragraph [0079]; figure 5 *<br>* paragraph [0019] *<br>* paragraph [0029] - paragraph [0030] *<br>* paragraph [0060] * | 1-15 | B60L7/10<br>B60L58/12<br>B60L58/16 |
| | ----- | | |
| Y | US 2016/315492 A1 (KAWAI HIROHITO [JP]) 27 October 2016 (2016-10-27)<br>* figure 2 *<br>* paragraph [0024] *<br>* paragraph [0029] *<br>* paragraph [0040] * | 1-15 | |
| | ----- | | |
| A | US 2013/015860 A1 (CROMBEZ DALE SCOTT [US]) 17 January 2013 (2013-01-17)<br>* paragraph [0060]; figure 4 * | 1,9,10,<br>12-15 | |
| | ----- | | |

**TECHNICAL FIELDS SEARCHED (IPC)**

B60L

The present search report has been drawn up for all claims

| Place of search | Date of completion of the search | Examiner |
|---|---|---|
| The Hague | 22 November 2024 | Benedetti, Gabriele |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 1711

This annex lists the patent family members relating to the patent documents cited in the above-mentioned European search report.
The members are as contained in the European Patent Office EDP file on
The European Patent Office is in no way liable for these particulars which are merely given for the purpose of information.

22-11-2024

| Patent document cited in search report | | Publication date | Patent family member(s) | | Publication date |
|---|---|---|---|---|---|
| US 2016368481 | A1 | 22-12-2016 | BR | 102016013953 A2 | 27-12-2016 |
| | | | CN | 106256633 A | 28-12-2016 |
| | | | DE | 102015007913 A1 | 22-12-2016 |
| | | | EP | 3106362 A1 | 21-12-2016 |
| | | | RU | 2016124109 A | 21-12-2017 |
| | | | US | 2016368481 A1 | 22-12-2016 |
| US 2016315492 | A1 | 27-10-2016 | CN | 105849997 A | 10-08-2016 |
| | | | DE | 112014006001 T5 | 03-11-2016 |
| | | | JP | 5842907 B2 | 13-01-2016 |
| | | | JP | 2015126574 A | 06-07-2015 |
| | | | US | 2016315492 A1 | 27-10-2016 |
| | | | WO | 2015097996 A1 | 02-07-2015 |
| US 2013015860 | A1 | 17-01-2013 | CN | 102881955 A | 16-01-2013 |
| | | | DE | 102012106268 A1 | 17-01-2013 |
| | | | RU | 2012129821 A | 27-01-2014 |
| | | | US | 2013015860 A1 | 17-01-2013 |

EPO FORM P0459

For more details about this annex : see Official Journal of the European Patent Office, No. 12/82